# EUROPÄISCHE PATENTANMELDUNG

(11) **EP 1 726 993 A1**
(43) Veröffentlichungstag der Anmeldung: **29.11.2006**
(21) Anmeldenummer: 06010728.1
(22) Anmeldetag: 24.05.2006
(51) Int. Cl.: G03F 7/20, G02B 27/00, G21K 1/06

(54) **Optisches System und Verfahren zum Betreiben desselben**

(30) Priorität: 24.05.2005 US 683880 P
(71) Anmelder: Carl Zeiss SMT AG, 73447 Oberkochen (DE)
(72) Erfinder: Mertens, Bas, 2517 RK Den Haag (NL); Weiss, Markus, 73431 Aalen (DE); Jansen, Rik, 1013 NN Amsterdam (NL); Van de Runstraat, Annemieke, 2919 RW Zoetermeer (NL); Van Mierlo, Hubert Adriaan, 3144 RA Maassluis (NL); Klinkhamer, Friso, 2611 GD Delft (NL); Nijkerk, Michiel David, 1057 JD Amsterdam (NL); Wieringa, Fokko Pieter, 6661 RE Elst (Gelderland) (NL); Wolschrijn, Bastiaan, Theodor, 1391 Abcoude (NL)
(74) Vertreter: Fuchs Mehler Weiss & Fritzsche

(57) **Zusammenfassung**

Es wird ein Verfahren zum Betreiben eines optischen Systems aus mindestens einem auf einem elektrischen Potential P₀ liegenden optischen Element für Strahlung im EUV- oder weichen Röntgenwellenlängenbereich beschrieben. Es ist mindestens eine erste Elektrode zum Auffangen von positiv geladenen Ionen vorgesehen, die relativ zu dem mindestens ein optisches Element auf ein niedrigeres Potential P₁₁ < P₀ (Betriebsmodus) und zur Messung von Sekundärelektronen auf ein höheres Potential P₁₂ > P₀ gelegt wird, wobei aus der Messung der Sekundärelektronen auf den Kontaminationsgrad des optischen Elementes geschlossen wird (Kontaminationskontrollmodus). Das optische Element sieht eine variable Spannungsquelle (50) vor, wobei das optische Element (18, 19) auf einem Potential P₀ und die erste Elektrode (20, 21) auf einem Potential P₁ liegt. Ferner ist eine Umschalteinrichtung (51) vorgesehen, um die erste Elektrode (20, 21) von dem Potential P₁₁ < P₀ auf ein Potential P₁₂ > P₀ umzuschalten und umgekehrt.

## Beschreibung

Die Erfindung betrifft ein Verfahren zum Betreiben eines optischen Systems aus mindestens einem auf einem elektrischen Potenzial P₀ liegenden optischen Elements für Strahlung im EUV- oder weichen Röntgenwellenlängenbereich und mindestens einer ersten Elektrode, wobei zwischen dem optischen Element und der ersten Elektrode während der Bestrahlung des optischen Elementes eine Potenzialdifferenz angelegt wird.

Unter optischen Elementen werden nachfolgend insbesondere Spiegel und Masken verstanden.

Eines der Hauptprobleme der Lithographie mit EUV-Strahlung oder weicher Röntgenstrahlung (z. B. bei Wellenlängen zwischen 1 und 20 nm) ist die Degradation der Oberfläche der optischen Elemente, insbesondere der in Lithographievorrichtungen eingesetzten Multilayer-Spiegel, wie sie z. B. aus der DE 100 16 008 bekannt sind. Diese Oberflächendegradation führt zu Reflektivitätsverlusten und Abbildungsfehlern. Es herrschen zwei Prozesse vor. Ein Prozess besteht in der Oxidation der Oberfläche, bei der die Oberfläche irreversibel zerstört wird. Der andere Prozess besteht im Aufwachsen von Kohlenstoff. Dieser zweite Prozess ist reversibel.

Um eine Lithographievorrichtung funktionsbereit zu halten, muss die Oberflächendegradation entweder rückgängig gemacht werden oder verhindert werden. Um Kontaminationen durch Kohlenstoff zu entfernen, muss eine reduzierende oder oxidierende Substanz eingesetzt werden. Dieser Prozess wird Reinigen genannt. Allerdings muss darauf geachtet werden, dass die Oberfläche des optischen Elementes nicht zu stark gereinigt wird, da dies zu einer Schädigung der Oberfläche führen würde.

Aus der DE 102 09 493 ist es bekannt, den Kontaminationsgrad durch Messung des durch Photoemission aus der bestrahlten Oberfläche des optischen Elementes erzeugten Photostroms zu messen. Der Photostrom wird zur Regelung der Gaszusammensetzung des Restgases eingesetzt, wobei die Gaszusammensetzung in Abhängigkeit von mindestens einem unteren und einem oberen Schwellenwert des Photostroms verändert wird. Als Detektiereinrichtung ist dabei ein über der Oberfläche des optischen Elementes angeordneter Elektronenfänger, wie z. B. ein Nachweisring oder ein Nachweisnetz vorgesehen, der derart angeordnet und/oder ausgebildet ist, dass er die einfallende EUV-Strahlung nicht beeinträchtigt.

Aus der europäischen Anmeldung EP 1 431 828 A1 ist es bekannt, zur Unterstützung der Reinigung von Oberflächen mit Hilfe von geladenen Teilchen wie z. B. Elektronen, Inertgasionen, Sauerstoffradikalen etc. ein elektrisches Feld vorzusehen, um die geladenen Teilchen auf die zu reinigende Oberfläche des optischen Elementes zu beschleunigen.

Insbesondere positiv geladene lonen werden auch während des normalen Betriebes eines Lithographiegerätes durch Wechselwirkung der EUV- oder weichen Röntgenstrahlung mit den Restgasen kontinuierlich erzeugt. Dabei handelt es sich überwiegend um Kohlenwasserstoffe, die zu einer Kontamination durch Kohlenstoffablagerung auf der Oberfläche des optischen Elementes führen.

Aufgabe der vorliegenden Erfindung ist es, ein Verfahren bereit zu stellen, das den Betrieb eines optischen Systems unter möglichst guter Ausschöpfung der maximalen Lebensdauer der vorhandenen optischen Elemente erlaubt. Ferner soll ein entsprechendes optisches System bereitgestellt werden.

Gelöst wird die Aufgabe durch ein Verfahren gemäß Patentanspruch 1.

Die mindestens eine erste Elektrode wird zum Auffangen von positiv geladenen lonen relativ zu dem mindestens einen optischen Element im ersten Modus auf ein niedrigeres, erstes Potenzial P₁₁ < P₀ (Betriebsmodus). Zur Messung insbesondere von Sekundärelektronen wird die erste Elektrode vorzugsweise im zweiten Modus auf ein höheres, zweites Potenzial P₁₂ > P₀ gelegt, wobei aus der Messung der Sekundärelektronen auf den Kontaminationsgrad des optischen Elementes geschlossen wird (Kontaminationskontrollmodus).

Im Betriebsmodus wird durch die angelegte Potentialdifferenz gewährleistet, dass positiv geladene lonen, die zu einer Oberflächendegradation führen können, von der ersten Elektrode angezogen werden und daher mit nur sehr geringer Wahrscheinlichkeit auf der Oberfläche des optischen Elementes auftreffen. Der Betriebsmodus ist während der Bestrahlung des optischen Elementes eingestellt.

Aufgrund der im Betriebsmodus angelegten Potentialdifferenz werden die aus der Oberfläche des optischen Elementes austretenden Sekundärelektronen, z. B. Photoelektronen, auf die Spiegeloberfläche gelenkt. Dies ist insbesondere bei gepulster EUV- bzw. weicher Röntgenstrahlung von Vorteil. Denn bei jedem Strahlungspuls treten in einem kurzen Zeitintervall vermehrt Sekundärelektronen aus der Oberfläche aus, was zu einer Aufladung des optischen Elementes führt. Diese plötzlichen Aufladungen können zu ungewollten Effekten, wie z. B. elektromagnetische Abstrahlung, führen. Durch die wegen des elektrischen Feldes auf die Oberfläche zurückfallenden Sekundärelektronen wird der Aufladungseffekt stark gemindert.

Im Kontaminationskontrollmodus kommt es darauf an, dass möglichst alle Sekundärelektronen, die aus der Oberfläche des optischen Elementes austreten, aufgefangen werden und nicht wieder zurückfallen. Über die Messung des aus den Sekundärelektronen resultierenden Stromes können Rückschlüsse auf den Kontaminationsgrad gezogen werden. Dies wird durch das gegenüber dem Betriebsmodus veränderte elektrische Feld gewährleistet, indem die Sekundärelektronen von der ersten Elektrode angezogen werden.

Durch Bestrahlung des optischen Elementes im Betriebsmodus, bei dem das optische Element vor positiven lonen geschützt wird, und gelegentliches Umschalten in den Kontaminationskontrollmodus, um zu entscheiden, ob das optische Element gereinigt werden muss, lässt sich die maximale Lebensdauer des mindestens einen optischen Elementes optimal ausnutzen. Denn einerseits wird im Betriebsmodus die Oberflächendegradation möglichst gering gehalten. Andererseits können ohne höheren Aufwand regelmäßige Kontrollmessungen durchgeführt werden. Denn dazu muss lediglich das angelegte Feld umgepolt werden. Daher können Überschreitungen der Toleranzgrenzen bei der Kontamination sehr schnell erkannt werden. Eine Reinigung ist nur in verringertem Maße notwendig, so dass die Wahrscheinlichkeit für ein "Überreinigen" und damit für eine irreversible Oxidation der Oberfläche vermindert wird.

Vorzugsweise wird während der Bestrahlung mindestens eine Umschaltung der ersten Elektrode von niedrigerem Potenzial P₁₁ auf höheres Potenzial P₁₂ und umgekehrt in regelmäßigen Zeitabständen durchgeführt. Die Umschaltung in den Kontaminationskontrollmodus kann beispielsweise jährlich, monatlich, wöchentlich oder täglich durchgeführt werden, was von den Betriebsbedingungen und der zu erwartenden Kontamination abhängt. Die Umschaltung wird vorzugsweise 1- bis 5mal pro 2 Stunden, insbesondere einmal pro Stunde durchgeführt.

Da im Kontaminationskontrollmodus positiv geladene lonen in Richtung auf das optische Element beschleunigt werden, ist zu beachten, dass die Dauer einer Kontaminationskontrolle möglichst gering gehalten wird, um eine Oberflächendegradation aufgrund der auftreffenden positiven lonen möglichst zu vermeiden.

Vorzugsweise wird die Zeitdauer des Kontaminationskontrollmodus kleiner gewählt als die Zeitdauer des Betriebsmodus gewählt.

Die Zeitdauer des Kontaminationskontrollmodus wird vorzugsweise auf 10 bis 60 Sekunden beschränkt.

Wenn eine gepulste Strahlung mit einer Pulsfrequenz verwendet wird und im Kontaminationskontrollmodus an die erste Elektrode eine Wechselspannung mit einer Frequenz gleich der Pulsfrequenz angelegt wird, schwankt die Wechselspannung zwischen dem niedrigerem Potenzial P₁₁ und dem höheren Potenzial P₁₂.

Die Dauer des Kontaminationskontrollmodus liegt in diesem Fall bei vorzugsweise < 1000, vorzugsweise bei 1 bis 100, insbesondere bei 1 bis 10, und besonders bevorzugt bei 4 bis 5 Pulsen der Strahlung. Im Kontaminationskontrollmodus können anstelle von gepulsten Messungen auch kontinuierliche Messungen durchgeführt werden.

Es hat sich gezeigt, dass vor allem folgende Elemente sich als erste Elektrode besonders eignen: ein um das optische System befindliches Gehäuse kann als Elektrode genutzt werden; eine in der Nähe des optischen Elements angeordnete Platte kann als Elektrode eingesetzt werden; die Elektrode kann auch als ein über dem zum optischen Element angeordnetes Gitter oder Ring ausgebildet sein. Bei allen drei Elektrodenarten ist es wichtig, dass sie möglichst wenig vom EUV- bzw. weichen Röntgenstrahl abschatten. Welche Elektrodenart bevorzugt wird, richtet sich nach den geometrischen Gegebenheiten des optischen Systems, der Restgaszusammensetzung, der Strahlungsintensität und den benötigten Potenzialen.

Vorzugsweise ist mindestens eine zweite Elektrode vorgesehen, die auf ein zweites Potenzial P₂ gelegt wird.

Es hat sich als vorteilhaft erwiesen, eine zusätzliche Spannungsdifferenz zwischen dem optischen Element und der zweiten Elektrode anzulegen. Die zweite Elektrode ist vorzugsweise räumlich weiter vom optischen Element entfernt angeordnet als die erste Elektrode. Prinzipiell kommen alle Elektrodengestaltungen in Frage, die auch für die erste Elektrode geeignet sind. Aufgrund der räumlich unterschiedlichen Anordnung ist es jedoch vorteilhaft, als zweite Elektrode das um das optische Element angeordnete Gehäuse vorzusehen und als erste Elektrode die in der Nähe des optischen Elements anzuordnenden Ausführungen wie Gitter; Ring oder Platte zu verwenden.

Durch die Kombination von mindestens zwei Elektroden, d. h. mindestens einer ersten und mindestens einer zweiten Elektrode, wird das Volumen, in dem sich ein starkes Feld befindet, reduziert. Damit verringert sich auch die Wahrscheinlichkeit, dass sich aufgrund des elektrischen Feldes unerwünschte Nebeneffekte einstellen.

Die zweite Elektrode wird dabei vorteilhafterweise auf relativ zum Potenzial P₀ des optischen Elements auf niedrigeres Potential P₂ gelegt. Bezüglich des ersten Potenzials P₁ gilt | P₁ | > | P₂ |. Wenn P₀ = 0 V beträgt, liegt das erste Potenzial P₁ bei minimal P₁₁ = - 100V bzw. bei maximal P₁₂ =100 V. Für P₂ ist ein Bereich von 0 bis ± 40 V bevorzugt. Insofern gilt vorzugsweise die allgemeine Bedingung | P₀ | < | P₂ | < | P₁ |.

Das Potenzial P₂ bleibt im Betriebs- und Kontaminationskontrollmodus unverändert. Besonders bevorzugt bleibt es im Betriebs- und Kontaminationskontrollmodus konstant.

Besonders gute Erfahrungen wurden damit gemacht, im Betriebsmodus das Potenzial P₁ unterhalb des Potentials des optischen Elementes und im Kontaminationskontrollmodus oberhalb des Potentials des optischen Elementes zu legen. Dabei wird vorzugsweise das Potential P₁, z. B. am Gitter geändert, da die Zeitkonstanten am Gitter in der Regel geringer als bei optischen Elementen sind.

In der soeben beschriebenen Ausführungsform wird durch das konstante globale elektrische Feld gewährleistet, dass sowohl im Betriebs- als auch im Kontaminationskontrollmodus frei bewegliche, positive lonen, die sich nicht im Bereich der Gitterelektrode befinden, permanent von der zweiten Elektrode angezogen werden, auch wenn sich das optische System im Kontaminationskontrollmodus befindet. Dadurch wird die Gefahr der Oberflächendegradation während der Kontaminationskontrolle verringert.

Falls zum Schutz vor Oberflächendegradation im optischen System eine bestimmte Restgasatmosphäre eingestellt ist, wie z. B. in der DE 103 21 103 beschrieben, können im Kontaminationskontrollmodus die Partialdrücke gesenkt werden, um darüber die Wahrscheinlichkeit der Erzeugung zusätzlicher positiver lonen zu verringern.

Das vorgeschlagene Verfahren weist den Vorteil auf, dass die Dichte freier, im optischen System befindlicher, positiv geladener Teilchen insgesamt geringer ist als bei herkömmlichem Betrieb. Auch dadurch wird die Oberflächendegradation mindestens eines optischen Elementes verringert. Denn höherenergetische freie Teilchen, die auf irgendwelche weiteren Bestandteile eines optischen Systems treffen, können zu Sputtereffekten führen, was zu zusätzlicher Verschmutzung der Oberfläche des optischen Elementes der Oberfläche führen kann.

Es hat sich als vorteilhaft erwiesen, zumindest im Kontaminationskontrollmodus dem optischen System ein Gas- oder Gasgemisch, insbesondere zu Reinigungszwecken zuzuführen. Dabei wird während des Reinigungsprozesses kontinuierlich und unmittelbar über die Messung der austretenden Sekundärelektronen das Fortschreiten des Reinigungsprozesses überwacht. Dies ermöglicht ein rechtzeitiges Abschalten des Reinigungsprozesses, bevor die kritische Grenze erreicht wird, ab der die Oberfläche des optischen Elementes irreversibel oxidiert wird. Vorteilhafterweise wird dabei das Gas oder Gasgemisch direkt auf die Oberfläche des einen optischen Elementes geführt.

Bei optischen Systemen mit zwei oder mehr optischen Elementen wird vorzugsweise so verfahren, dass jeweils nur ein optisches Element in den Kontaminationskontrollmodus geschaltet wird, während die übrigen optischen Elemente im Betriebsmodus bleiben. Einerseits stören sich die unterschiedlichen Felder der einzelnen optischen Elemente nicht. Andererseits werden die übrigen optischen Elemente im Betriebsmodus weiterhin vor positiven lonen geschützt, während bei dem einen optischen Element der Kontaminationsgrad überprüft wird.

Es hat sich als vorteilhaft herausgestellt, im Kontaminationskontrollmodus ein gepulstes elektrisches Feld zu verwenden. Dadurch werden nach wie vor im Wesentlichen alle Sekundärelektronen von der Oberfläche des optischen Elementes entfernt. Es werden aber doch weniger positive Ionen angezogen.

Das optische System, weist mindestens ein optisches Element für Strahlung im EUV- oder weichen Röntgenwellenlängenbereich, mindestens eine erste Elektrode und eine variable Spannungsquelle zur Erzeugung einer Potenzialdifferenz zwischen dem optischen Element und der ersten Elektrode auf. Das optische Element liegt auf einem Potenzial P₀ und die erste Elektrode auf einem Potenzial P₁ und es ist eine Umschalteinrichtung vorgesehen, um das Potenzial P₁ von einem ersten Wert P₁₁ < P₀ im Betriebsmodus des optischen Systems auf einen zweiten Wert P₁₂ > P₀ im Kontaminationskontrollmodus des optischen Systems umzuschalten und umgekehrt.

Vorzugsweise besitzt die Umschalteinrichtung eine Zeitschalteinrichtung.

Bei optischen Systemen, bei denen die mindestens eine erste Elektrode als ein in der Nähe der optisch aktiven Fläche des optischen Elementes angeordnetes Gitter ausgebildet ist, hat es sich als vorteilhaft erwiesen, das Gitter aus Drähten aus inertem Material zu bilden. Besonders bevorzugt sind dabei Drähte aus Wolfram oder Wolfram-Rhenium. Wolfram weist einen niedrigen spezifischen Widerstand und eine hohe Schmelztemperatur auf. Außerdem wird Wolfram weder durch Sauerstoffradikale noch EUV-Strahlung angegriffen. Die Zugabe von Rhenium macht Wolfram duktiler.

Insbesondere bei Drahtgittem sind die Drähte vorteilhafterweise auf einem Rahmen aufgespannt. Es hat sich daher als vorteilhaft erwiesen, die vom Gitter überdeckte Fläche größer als die Fläche des Strahlflecks bei Bestrahlung mit EUV- oder weicher Röntgenstrahlung zu wählen. Dadurch wird verhindert, dass Strahlung abgeschattet wird. Um möglichst wenig von der Strahlung abzuschatten, empfiehlt es sich außerdem, das Gitter senkrecht zur Scannerbewegung vorzusehen, falls das optische System in einem Lithographiegerät eingesetzt wird, das nach dem Step and Scan-Prinzip funktioniert. Dadurch wird die Abschattung durch das Gitter "verwaschen".

Es empfiehlt sich, Potenzialdifferenzen, d. h. P₀ - P₁ stets < 100 V zu setzen, da sich sonst ungewollte Entladungserscheinungen ergeben können, insbesondere wenn es sich bei der ersten Elektrode um ein Gitter handelt. Die Elektrodenpotenziale sollten aber dennoch so hoch sein, dass sich die erste Elektrode in einem Sättigungsbereich befindet, so dass die erste Elektrode nicht auf sich ändemde elektrische Streufelder oder sich ändemde Gaspartialdrücke reagiert. Dies ist insbesondere wichtig, wenn über die erste Elektrode die Sekundärelektronen zur Bestimmung des Kontaminationsgrades gemessen werden sollen.

Um den Einfluss von Aufladungseffekten am optischen Element, insbesondere durch gepulste EUV- oder weiche Röntgenstrahlung zu vermindern, weist das optische System vorteilhafterweise mindestens eine am optischen Element angeschlossene elektrische Zuleitung auf, wobei das optische Element auf ein beliebiges Potenzial P₀ legbar ist. Über diese Zuleitung können die bei Bestrahlung austretenden Sekundärelektronen schnell durch nachgeführte Ladungsträger ersetzt werden. Der dann in der Zuleitung fließende Strom kann ebenfalls als Maß für die Anzahl der Sekundärelektronen und damit für den Grad der Kontamination ausgewertet werden.

In einer besonders bevorzugten Ausführungsform ist die erste Elektrode derart ausgebildet, dass sie mindestens eine Gaszuführeinrichtung und einen Gasauslaß aufweist. Besonders bevorzugt weist sie eine Mehrzahl von Gasausläßen auf. Vorteilhafterweise sind diese auf die optisch aktive Fläche des optischen Elementes gerichtet. Indem die Größe des oder der Gasausläße klein genug gewählt wird und/oder die Pumpleistung am Gaseintritt erhöht wird, wird beim Austritt aus dem Gasauslaß ein relativ zum Umgebungsdruck höherer lokaler Druck erzeugt. Das Gas kann entweder zu Reinigungszwecken dienen oder dazu, im Betriebsmodus die gewünschte Restgasatmosphäre einzustellen. Besonders vorteilhaft ist es, wenn der mindestens eine Gasauslaß auf die optisch aktive Fläche des optischen Elementes gerichtet ist. Dadurch stellt sich im Bereich der Oberfläche des optischen Elementes der notwendige Druck ein, um die Oberfläche zu reinigen bzw. vor Kontamination zu schützen.

Die optischen Systeme können z. B. für die Beleuchtung oder die Projektion von abzubildenden Strukturen verwendet werden. Aus einem oder mehreren optischen Systemen lassen sich Lithographiegeräte für die EUV- oder weiche Röntgenstrahlung herstellen. Mit Hilfe derartiger Lithographiegeräte lassen sich Bauelemente lithographisch herstellen, indem mit Hilfe mindestens eines optischen Systems und EUV- oder weicher Röntgenstrahlung Strukturen auf ein Substrat abgebildet werden.

Das oder die optischen Elemente sind, wie eingangs erwähnt, beispielsweise Spiegel und Masken. Hiervon sind insbesondere auch "normal incidence"-Kollektorspiegel umfasst, wie beispielsweise in der WO 2005/031748 A1 beschrieben, deren Inhalt vollumfänglich in die vorliegende Anwendung aufgenommen wird. Solche Kollektorspiegel weisen eine Multilayerbeschichtung zur Verbesserung der Reflektionseigenschaften auf. Da sie naturgemäß besonders nahe der Strahlungsquelle angeordnet sind, sind sie auch einer entsprechend großen Kontaminationsgefahr ausgesetzt. Daher findet das erfindungsgemäße Verfahren bzw. die erfindungsgemäße Elektrodenanordnung besonders bevorzugt auch auf solche Kollektorspiegel Anwendung.

Die Aufgabe wird mithin durch einen normal-incidence-Kollektorspiegel für Strahlung im EUV- oder weichen Röntgenwellenlängenbereich gelöst, welcher einen elektrischen Kontakt zum Anschließen einer Spannungsquelle aufweist. Bevorzugt ist dem normal-incidence-Kollektorspiegel mindestens eine erste Elektrode zugeordnet. Hierdurch wird die Anwendung des zuvor beschriebenen Verfahrens auf normal-incidence-Kollektorspiegel ermöglicht.

Das optische System mit einem solchen normal-incidence-Kollektorspiegel umfasst, wie zuvor beschrieben, eine mit dem elektrischen Kontakt und der Elektrode verbundene Spannungsquelle zur Erzeugung einer Potentialdifferenz zwischen dem normal-incidence-Kollektorspiegel und der ersten Elektrode. Die Spannungsquelle ist vorzugsweise eingerichtet, im Betriebsmodus des optischen Systems während der Bestrahlung des normal-incidence-Kollektorspiegels, den normal-incidence-Kollektorspiegel auf ein Potential P₀ und die erste Elektrode auf ein Potential P₁ mit einem ersten Wert P₁₁ < P₀ zu legen. Die Spannungsquelle ist in einer bevorzugten Ausführungsform variabel und weist eine Umschalteinrichtung auf, wobei die Spannungsquelle bzw. die Umschalteinrichtung eingerichtet ist, das Potential P₁ von dem ersten Wert P₁₁ < P₀ auf einen zweiten Wert P₁₂ > P₀ im Kontaminationskontrollmodus des optischen Systems umzuschalten und umgekehrt.

Die Erfindung soll anhand der Zeichnungen näher erläutert werden.
Dazu zeigen
- Figur 1: einen schematischen Aufbau eines Lithographiegerätes;
- Figur 2: ein optisches System mit zwei optischen Elementen, die sich im Betriebsmodus befinden;
- Figur 3: ein optisches System mit zwei optischen Elementen, von denen sich eines im Betriebsmodus und das andere im Kontaminationskontrollmodus befindet;
- Figur 4a: das Intensitätszeitdiagramm der EUV-Strahlung;
- Figur 4b und c: einen zeitlichen Verlauf der Spannungen an dem einen oder dem anderen optischen Element;
- Figur 5: eine bevorzugte Ausführungsform des optischen Systems;
- Figuren 6a, b: Detailansichten der in Figur 5 gezeigten Ausführungsform und
- Figur 7: den Aufbau eines Lithographiesystems mit einem Schwarzlicht-Kollektorensystem, aufweisend zwei erfindungsgemäße normal-incidence-Kollektorspiegel.

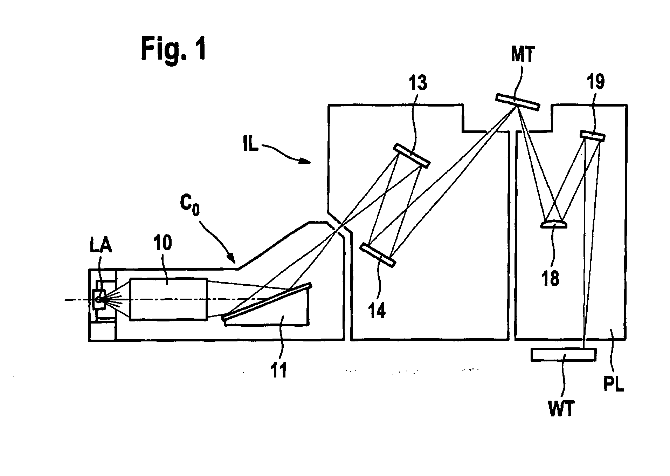

In Figur 1 ist schematisch eine Ausführungsform eines Lithographiegerätes dargestellt. Das Lithographiegerät besteht im Wesentlichen aus drei Hauptteilen: Ein Kollektor C₀ zur Strahlerzeugung, ein optisches System IL zur Beleuchtung der Maske MT und ein Projektionssystem PL zur Abbildung der Maskenstruktur auf einem Wafer WT. Als Lichtquelle LA können eine Quecksilberlampe, Excimer-Laser, ein Synchrotron, ein Wigger oder ein Undulator sowie ein laserinduziertes Plasma dienen.

Das Licht wird in einem Kollektor 10 und durch Beugung an einem optischen Gitter 11 für das optische Beleuchtungssystem IL konditioniert.

Sowohl im optischen System IL als auch im optischen System PL befinden sich jeweils zwei reflektive optische Elemente 13, 14 und 18, 19 in Form von Multilayer-Spiegeln.

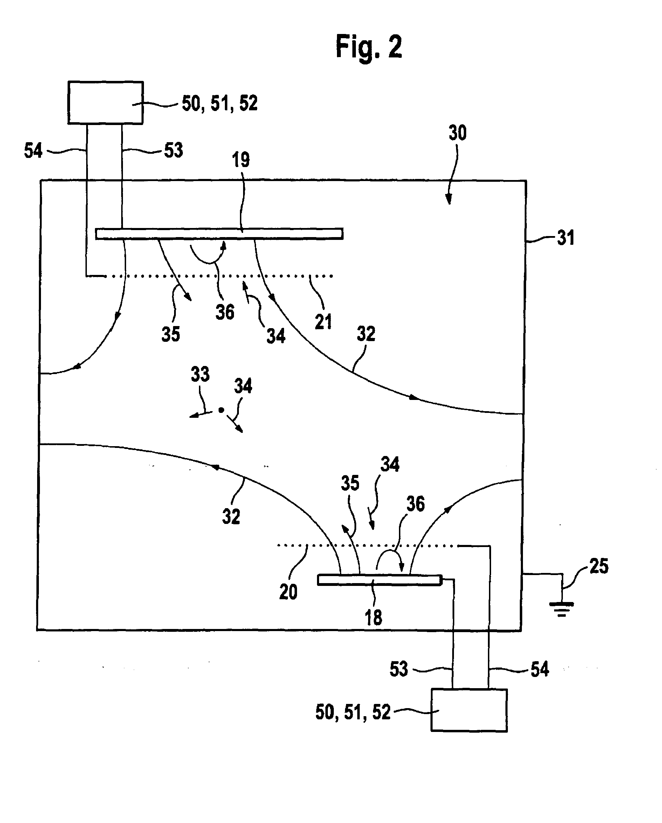

In Figur 2 ist schematisch die Funktionsweise des optischen Systems PL näher erläutert. Das optische System IL funktioniert auf die gleiche Art und Weise. Die zwei Multilayer-Spiegel 18 und 19 sind einander gegenüber angeordnet. Sie befinden sich in einer Vakuumkammer 30, deren Wand 31 als zweite Elektrode über eine elektrische Zuleitung 25 z. B. auf Erdpotenzial (P₂) gelegt werden kann. Dem gegenüber weisen die Spiegel 18 und 19 ein Potenzial P₀ von jeweils + 40 V auf. Dadurch wird ein elektrisches Feld aufgebaut, das, wie durch die Feldlinien 32 angedeutet, positiv geladene lonen 33 ablenkt.

Elektronen 34 werden hingegen von den Spiegeln 18 und 19 angezogen. Vor jedem Spiegel 18, 19 ist außerdem eine erste Elektrode in Form eines Gitters 20, 21 angeordnet, die jeweils über eine Spannungsquelle 50 mit integrierter Umschalteinrichtung 51 und Zeitschalteinrichtung 52 mit den optischen Elementen 18, 19 verbunden ist. Die Gitter 20, 21 befinden sich auf einem Potenzial P₁ zwischen 0 V und + 40 V. Die Gitter 20, 21 dienen einerseits dazu, die Spiegeloberflächen vor positiven lonen zu schützen. Ferner beschleunigen sie Sekundärelektronen 35, die den Bereich zwischen Gitter 20, 21 und Spiegel 18, 19 verlassen. Niederenergetische Sekundärelektronen 36 fallen wieder auf den Spiegel 18, 19 zurück. Die höher energetischen Sekundärelektronen 35 treffen teilweise auch auf die Wand 31 des Gehäuses des optischen Systems PL.

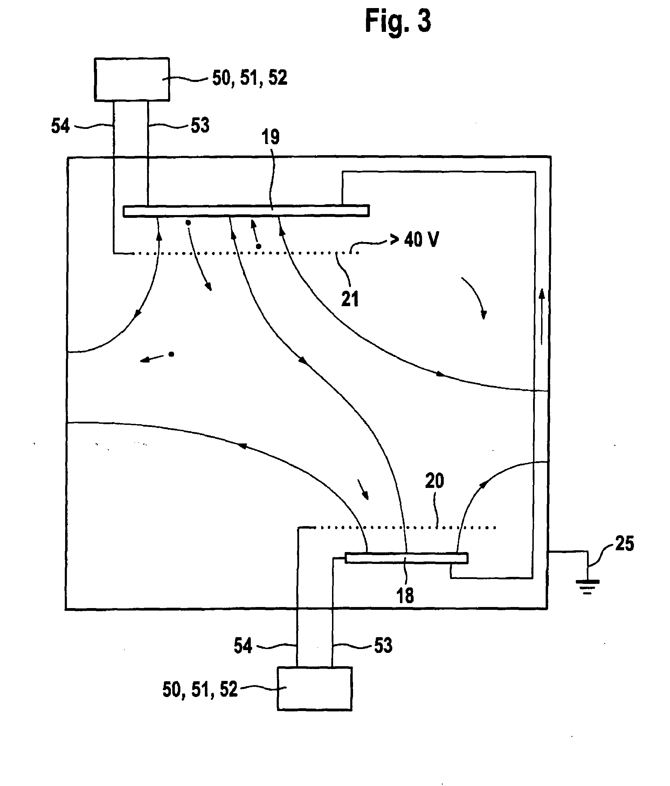

In Figur 3 ist die Situation dargestellt, dass das Potenzial P₁ am Gitter 21 vor dem Multilayer-Spiegel 19 auf ein Potenzial größer +40 V, also größer das Potenzial P₀ des optischen Elementes gesetzt wurde. Dadurch zieht das Gitter 21 austretende Sekundärelektronen an. Der Multilayer-Spiegel 19 befindet sich also im Kontaminationskontrollmodus, während sich der Multilayer-Spiegel 18 nach wie vor im Betriebsmodus befindet und vor jeglichen positiven Ionen geschützt ist. Die Spiegel 18 und 19 sind im vorliegenden Beispiel leitend miteinander verbunden, wobei auch Kontroll- und Messelektronik zwischengeschaltet sein kann. Das Elektronendefizit am Spiegel 19, das durch vollständigen Austritt aller Sekundärelektronen auf das Gitter 21 zu verursacht wird, wird durch die überschüssigen Elektronen am Spiegel 18 ausgeglichen. Der dabei fließende Strom ist proportional zur Anzahl der ausgetretenen Sekundärelektronen. Daraus kann auf den Kontaminationsgrad des Spiegels 19 zurück geschlossen werden.

In der nachfolgenden Tabelle sind beispielhafte Potenzialkombinationen aufgeführt:

| Potenzial | Betriebsmodus | Kont. Kontrollmodus |
|---|---|---|
| P₀ | + 40 | - 40 |
| P₁ | 0 bis + 40 V | 0 bis + 40 V |
| P₂ | 0 | 0 |

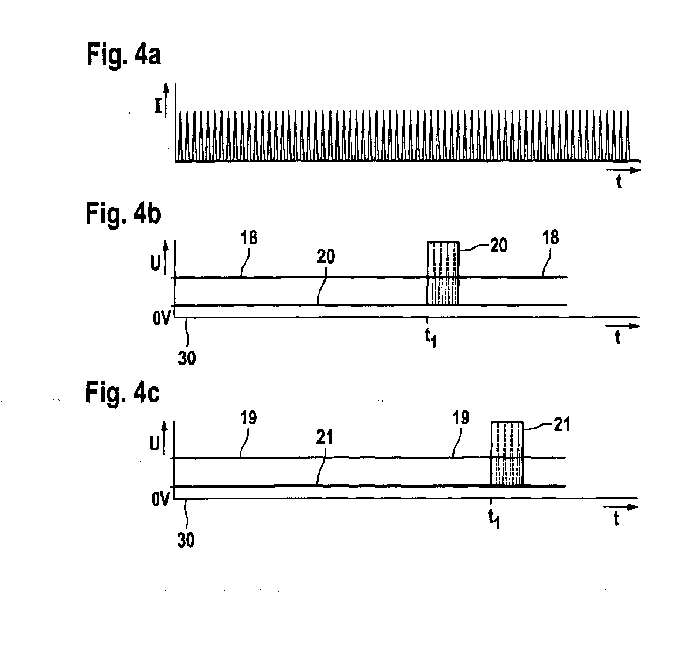

In den Figuren 4a - c ist der zeitliche Ablauf der unterschiedlichen Modi illustriert. In Figur 4a ist die gepulste Zeitstruktur der EUV-Strahlungsintensität zu erkennen. In Figur 4b sind zeitlichen Potenzialverläufe am Spiegel 18 sowie dem Gitter 20 und in Figur 4c die Potenzialverläufe am Multilayer-Spiegel 19 und Gitter 21 dargestellt. In einem ersten Zeitabschnitt sind beide Spiegel 18, 19 und Gitter 20, 21 auf einem konstanten Potenzial. Beide Potenziale P₁ liegen höher als das Potenzial P₂ der Wand 31 der Vakuumkammer 30. Außerdem liegt das Spiegelpotenzial P₀ über dem Gitterpotenzial P₁, so dass die positiven lonen von dem jeweiligen Spiegel 18, 19 abgestoßen werden. Zu einer Zeit t₁ wird das Potenzial P₁ am Gitter 20 auf ein Niveau oberhalb des Spiegelpotenzials P₀ erhöht. Dadurch wird der Spiegel 18 in den Kontaminationskontrollmodus geschaltet.

Wegen des negativen Einflusses der positiven lonen auf die Oberfläche des Spiegels 18 sollte der Kontaminationskontrollmodus nicht zu lange dauern. Die Zeitdauer von 4 bis 5 EUV-Pulsen reicht aus, um den Kontaminationsgrad feststellen zu können. Bei der vorliegenden Auslegung des optischen Systems wird einmal pro Stunde in den Kontaminationskontrollmodus geschaltet.

Um den negativen Einfluss der positiven lonen zu verringern, wird das Feld durch Anlegen von Wechselspannung an das Gitter 20, 21 gepulst. Dabei wurde es mit den Pulsen der EUV-Strahlung synchronisiert, um die Sekundärelektronen genau dann abzusaugen, wenn sie durch ein EUV-Puls erzeugt werden.

Aus dem Vergleich der Figuren 4b und c erkennt man, dass zunächst der Spiegel 18 und erst später der Spiegel 19 in den Kontaminationskontrollmodus geschaltet wird, während der jeweils andere Spiegel 18, 19 sich im Betriebsmodus befindet. Dadurch wird der im Betriebsmodus befindliche Spiegel 18, 19 vor Teilchen des im Kontaminationskontrollmodus befindlichen Spiegels geschützt. Außerdem kann durch die in Figur 3 beschriebene Messmethode dann eindeutig der Kontaminationsgrad eines bestimmten Spiegels bestimmt werden.

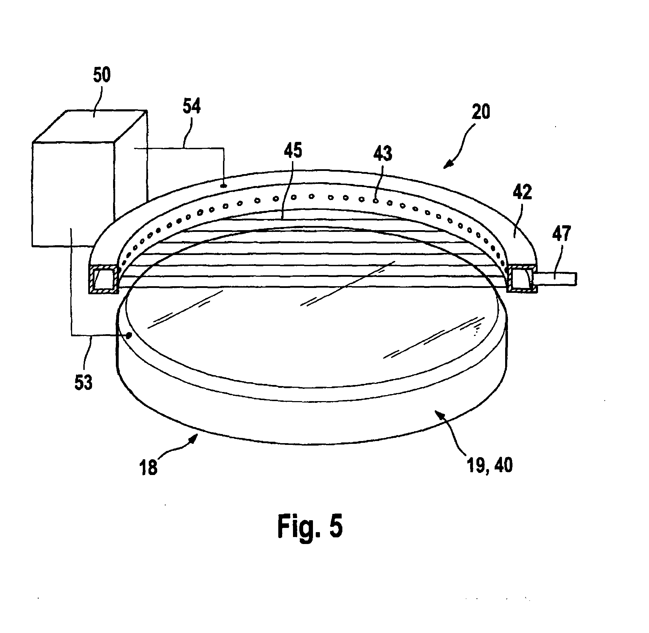

In Figur 5 ist eine Einheit aus einem optischen Element 18 in Form eines Multilayerspiegels 40 und einem Gitter 20 dargestellt. Das Gitter 20, das die erste Elektrode 19 bildet, wird durch einen Rahmen 42 und einen aufgespannten Draht 45 gebildet.

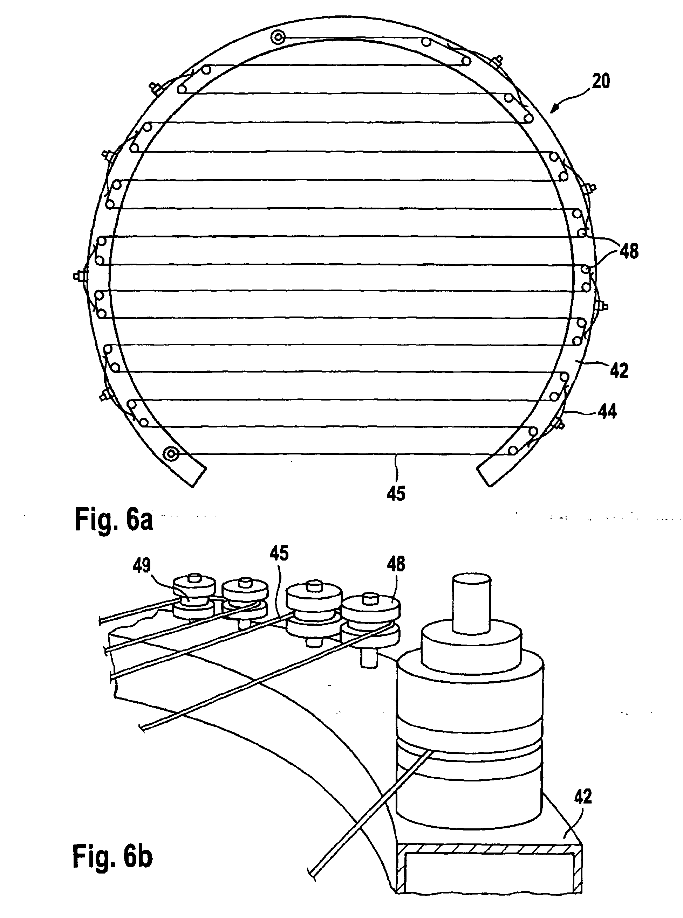

Dies ist in den Figuren 6a und 6b deutlicher zu erkennen. Der Wolfram-Rhenium-Draht 45 wird über elektrisch leitende Rollen 48 gespannt. Diese Rollen 48 sind leitend mit dem Metallrahmen 42 verbunden. Um das Gitter 20 in der Gitterebene auszurichten, weisen die Rollen 48 Rillen 49 zur Definition der Position des Drahtes relativ zum Rahmen 42 auf. Ferner sind am Rahmen 42 Blattfedern 50 vorgesehen, die mit den Rollen 48 zusammenwirken. Diese Blattfedern 50 sollen eventuelle Wärmeausdehnungen des Drahtes 50 durch Bestrahlung mit EUV-Strahlung oder Teilchen ausgleichen.

Auch die Blattfedern 44 sind elektrisch leitend mit dem Metallrahmen 42 verbunden. Die Drähte 45 haben einen Abstand zueinander von 10 mm und einen längste Ausdehnung von 100 mm. Der Abstand der Drähte 45 zum optischen Element 18 beträgt auch 10 mm. Die Drahtdicke beträgt 10 µm.

Durch diese Dimensionierung wird erreicht, dass Schwankungen des elektrischen Feldes über die gesamte Gitterfläche im Bereich von +- 10 % bleiben. Außerdem wird nicht mehr als 0,1 % des Strahles abgeschattet. Dazu trägt auch bei, dass der Rahmen 42 in seiner Form der Außenkontur des Multilayer-Spiegels 40 folgt. Allgemein ist zu sagen, dass mit Drahtdicken zwischen 4 und 24 µm gut gearbeitet werden kann.

Der Metallrahmen 42 ist als Hohlrohr ausgebildet. Dieses Hohlrohr weist eine Gaszuführung 47 auf sowie eine Vielzahl von Gasausläßen 43 auf. Die Gasausläße 43 haben eine Fläche von ca. 100 µm x 100 µm. Auf der Rahmeninnenseite sind ca. 10.000 Gasausläße 43 angeordnet. Bei einem Gasdruck von 10⁻⁵ mbar am Gaseinlaß 47 wird an der Oberfläche des Multilayerspiegels 40 ein lokaler Druck von 10⁻⁴ mbar bei Einleiten von Sauerstoff zu Reinigungszwecken erreicht. Da die Gasausläße 43 auf der Hohlrohrinnenseite angeordnet sind, strömt der Sauerstoff auf die Oberfläche des zu reinigenden Multilayers 40.

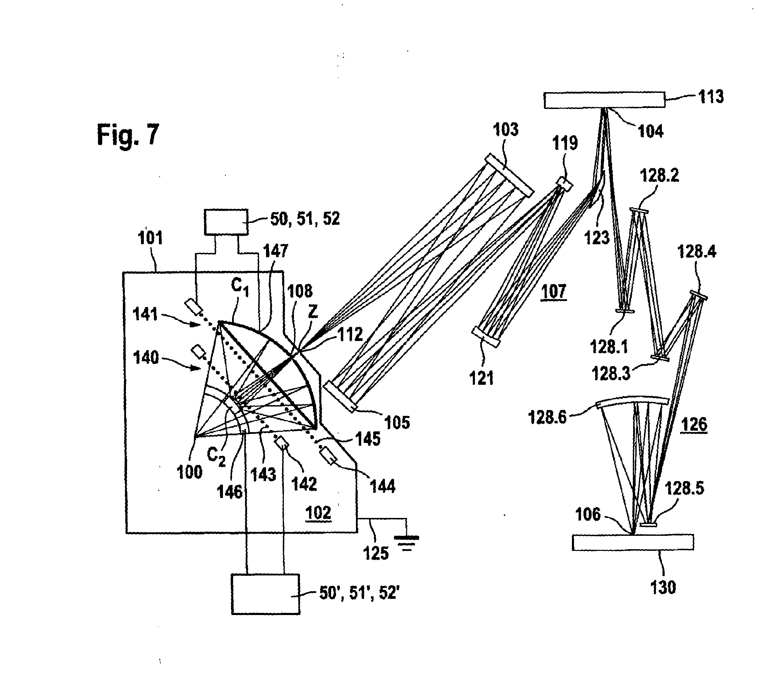

In Figur 7 wird der typische Aufbau eines EUV-Lithographiesystems für die Mikrolithographie dargestellt, welches ein Schwarzschild-Kollektorsystem 102 umfasst.

Die schematisch vereinfachte Darstellung des Schwarzschild-Kollektorsystems 102 zeigt einen ersten erfindungsgemäßen normal-incidence-Kollektorspiegel C1, der durch seine konkave, beispielsweise parabolische oder elliptische Ausformung Licht von der Lichtquelle 100 aufnimmt und auf den zweiten erfindungsgemäßen normal-incidence-Kollektorspiegel C2 zurückfaltet, der wiederum hyperbolisch oder ellipsoidförmig ausgebildet sein kann. Dieser zweite normal-incidence-Kollektorspiegel C2 ist so zentriert zum ersten normal-incidence-Kollektorspiegel C1 angeordnet, dass ein symetrisches Kollektorsystem entsteht, welches die Lichtquelle 100 auf ein vergrößertes Zwischenbild Z abbildet. Für die vom zweiten normal-incidence-Kollektorspiegel C2 ausgehende Strahlung ist ein Durchgang 108 im ersten normal-incidence-Kollektorspiegel C1 vorgesehen. Demnach wird vom ersten normal-incidence-Kollektorspiegel C1 Licht von der Lichtquelle 100 mit einem ersten Aperturwinkel aufgenommen und mit einem zweiten Aparturwinkel zum zweiten normal-incidence-Kollektorspiegel C2 abgestrahlt. Dem vom zweiten normal-incidence-Kollektorspiegel C2 ausgehende Strahlbüschel wird wiederum ein dritter Aperturwinkel zugeordnet. Unter Aperturwinkel wird in der vorliegenden Anmeldung der Winkel zwischen dem Randstrahl eines Strahlenbüschels mit dem maximalen Strahlwinkel zur optischen Achse verstanden. Bei den bei EUV-Beleuchtung vorliegenden Vakuumbedingungen ergibt sich dann die numerische Apertur aus den Sinus des Aperturwinkels.

Beide Kollektorspiegel C1 und C2 liegen erfindungsgemäß auf einem elektrischen Potenzial P₀¹ bzw. P₀². Jedem der Kollektoren C1 und C2 ist jeweils eine erste Gitterelektrode 140 bzw. 141, bestehend aus einem Rahmen 142 bzw. 144 und einem Draht 143 bzw. 145 zugeordnet. Die Rahmen sind so bemessen, dass sie die Strahlengeometrie nicht behindem, die Aperturwinkel also unverändert bleiben.

Des Weiteren gezeigt in Figur 7 sind im Lichtweg ausgehend von einer Lichtquelle 100 zu einer ausgeleuchteten Ebene, die als Feldebene 113 bezeichnet wird, optische Komponenten eines Beleuchtungssystems sowie des Projektionsobjektiv 126 einer Projektionsbelichtungsanlage.

Die Ausbildung eines Zwischenbilds Z der Lichtquelle 100 ist von Vorteil, da es so möglich ist, die Lichtquelle 100 und das Kollektorsystem 102 in ein vom nachfolgenden System atmosphärisch getrenntes Kompartiment einzuschließen. Ein solches Kompartiment ist in Figur 7 skizziert und mit dem Bezugszeichen 101 versehen. Außerdem ist es aufgrund der Ausbildung des Zwischenbilds Z der Lichtquelle 100 möglich, eine Blende 112, welche beispielsweise mit einem Gitterspektralfilter für die spektrale Filterung der Beleuchtung zusammenwirkt, in den Strahlengang aufzunehmen.

Die Wand des Kompartiments 101 kann als zweite Elektrode über eine elektrische Zuleitung 125 zum Beispiel auf Erdpotential (P₂) gelegt werden. Demgegenüber weisen die Kollektorspiegel C1 und C2 beispielsweise ein Potential P₀¹ bzw. p₀² von jeweils + 40 V auf. Die ersten Elektroden 140, 141 sind, wie im Zusammenhang mit Figur 2 erläutert, jeweils über eine zugeordnete Spannungsquelle 50' mit integrierter Umschalteinrichtung 51' und Zeitschalteinrichtung 52' über elektrische Kontakte 146, 147 an den Kollektorspiegeln C2 bzw. C1 mit diesen elektrisch leitend verbunden, so dass diese beispielsweise auf ein Potential P₁₁¹ bzw. P₁₁² zwischen 0 V und + 40V gelegt werden.

Während in dem so eingestellten Betriebsmodus positiv geladene lonen durch das elektrische Feld von den Kollektorspiegeln C1 und C2 in Richtung der Elektroden 141 bzw. 140 abgelenkt werden, kann das Potential der Kollektorspiegel C1 und C2 im Kontamination-Kontrollmodus beispielsweise auf - 40 V abgesenkt oder das Potential der Gitter P₁₂¹ bzw. P₁₂² auf über + 40 V angehoben werden, wobei dies bevorzugt nicht für beide Spiegel gleichzeitig geschieht. Dies ist insbesondere dann sinnvoll, wenn ähnlich wie in Figur 3, beide Spiegel C1 und C2 leitend miteinander verbunden sind, hier nicht dargestellt.

Des Weiteren sind in Figur 7 die dem erfindungsgemäßen Kollektorsystem 102 im Lichtweg von der Lichtquelle 100 zur ausgeleuchteten Feldebene 113 nachgeordneten optischen Komponenten des Beleuchtungssystems sowie das Projektionsobjektiv 126 gezeigt. Im Einzelnen ist in Figur 7 folgendes dargestellt: Ein Retikel bzw. eine Maske 104 wird in der Feldebene 113 eines Projektionsbelichtungssystems positioniert und mittels einer Reduktionsoptik 126 auf dessen Bildebene 130 abgebildet, in der sich typischerweise ein mit einem lichtempfindlichen Material versehener Wafer 106 befindet. Figur 7 zeigt hierzu beispielhaft ein Projektionsobjektiv bestehend aus sechs Einzelspiegein 128.1 bis 128.6, das beispielsweise aus der US 6 600 552, die vollumfänglich in die vorliegende Anmeldung mit aufgenommen wird, hervorgeht. Skizziert ist ferner eine im Idealfall tlezentrische Beleuchtung der Bildebene 130, d. h. der Hauptstrahl eines Strahlenbüschels, welcher von einem Feldpunkt der Feldebene 113 ausgeht, schneidet die Bildebene 130 senkrecht. Ferner weist das Projektionsobjektiv 126 eine Eintrittspupille auf, die im Allgemeinen, mit der Austrittspupille des Beleuchtungssystems zusammenfällt.

Figur 7 zeigt außerdem den typischen Aufbau eines EUV-Beleuchtungssystems, welches als doppeltfacettiertes Beleuchtungssystem gemäß der US 6 198 793 B1 ausgebildet wird, wobei der Inhalt dieses Dokuments vollumfänglich in die vorliegende Anmeldung mit aufgenommen wird. Ein solches System umfasst ein erstes optisches Element mit ersten Rasterelementen 103, welches auch als Feldfacettenspiegel 103 bezeichnet wird. Im Strahlengang anschließend folgt ein zweites optisches Element mit zweiten Rasterelementen 105, das üblicherweise Pupillenfacettenspiegel 105 genannt wird.

Feld- und Pupillenfacettenspiegel 103, 105 dienen zur Ausleuchtung eines Felds in der Feldebene 113 sowie der Gestaltung der Ausleuchtung in der Austrittspupille des Beleuchtungssystems. Die Wirkung jeder Feldwabe ist dergestalt, dass die ein Bild der Lichtquelle 100 ausbildet, wobei durch die Vielzahl Feldfacetten eine Vielzahl von so genannten sekundären Lichtquellen gebildet wird. Die sekundären Lichtquellen werden in oder nahe der Ebene, in welcher der Pupillenfacettenspiegel 105 angeordnet ist, ausgebildet. Damit, wie in Figur 7 dargestellt, die sekundären Lichtquellen im Bereicht des Pupillenfacettenspiegels 105 zu liegen kommen, können die Feldfacetten selbst eine optische Wirkung, beispielsweise eine sammelnde optische Werkung, aufweisen. Von den nachfolgenden optischen Elementen werden diese sekundären Lichtquellen als tertiäre Lichtquelle in die Austrittspupille des Beleuchtungssystems abgebildet.

Ferner wird jede Feldwabe durch die Facetten des Pupillenfacettenspiegels 105 und den nachfolgenden optischen Elementen der zweiten optischen Komponente 107, die im Beispiel aus Figur 7 aus den drei optischen Elementen erstes reflektives optisches Element 119, zweites reflektives optisches Element 121 und den grazing-incidence-Spiegel 123 bestehen, in die Feldebene 113 abgebildet. Die sich dort überlagemden Bilder der Feldfacetten dienen zur Ausleuchtung einer Maske 104 in der Feldebene 113, wobei typischerweise, ausgehend von rechteckförmigen oder bogenförmigen Feldfacetten, eine Ausleuchtung in der Feldebene 113 in der Form eines Ringfeldsegments entsteht. Im Allgemeinen ist das Mikrolithographiesystem als scannendes System ausgebildet, so dass die Maske 104 in der Feldebene 113 und eine Wafer 106 in die Bildebene 130 synchron bewegt werden, um eine Ausleuchtung bzw. eine Belichtung zu bewirken.

### Bezugszeichenliste

- 10: Kollektor
- 11: Gitter
- 13: optisches Element
- 14: optisches Element
- 18: optisches Element
- 19: optisches Element
- 20: Gitterelektrode
- 21: Gitterelektrode
- 25: elektrische Zuleitung
- 30: Vakuumkammer
- 31: Wand der Vakuumkammer
- 32: Feldlinien
- 33: positiv geladene lonen
- 34: Elektronen
- 35: Sekundärelektronen
- 36: Sekundärelektronen
- 40: Multilayerspiegel
- 42: Rahmen
- 43: Gasauslass
- 44: Blattfeder
- 45: Draht
- 47: Gaszuführung
- 48: Rolle
- 49: Rille
- 50,50': Spannungsquelle
- 51,51': Umschalteinrichtung
- 52, 52': Zeitschalteinrichtung
- 53: Zuleitung
- 54: Zuleitung
- 100: Lichtquelle
- 101: Kompartiment zum Einschluss der Lichtquelle 100 und des Kollektorsystems 102
- 102: Kollektorsystem
- 103: erstes optisches Element mit ersten Rasterelementen (Feldfacettenspiegel)
- 104: strukturtragende Maske
- 105: zweites optisches Element mit ersten Rasterelementen (Pupillenfacettenspiegel)
- 106: mit einem lichtempfindlichen Material versehener Wafer
- 107: zweite optische Komponente
- 108: Durchgang im ersten normal-incidence Spiegel
- 112: Blende
- 113: Feldebene
- 119: erstes reflektives optisches Element
- 121: zweites reflektives optisches Element
- 123: grazing-incidence Spiegel
- 125: Zuleitung
- 126: Projektionsobejtiv
- 128.1, 128.2,: Spiegel des Projektionsobjektiv
- 128.3, 128.4,:
- 128.5, 128.6:
- 130: Bildebene
- 140: Gitterelektrode
- 141: Gitterelektrode
- 142: Rahmen
- 143: Draht
- 144: Rahmen
- 145: Draht
- 146: Kontakt
- 147: Kontakt

- C1: erster normal-incidence-Kollektorspiegel
- C2: zweiter normal-incidence-Kollektorspiegel

## Patentansprüche

1. Verfahren zum Betreiben eines optischen Systems aus mindestens einem auf einem elektrischen Potenzial P₀ liegenden optischen Element (18, 19, C1, C2) für Strahlung im EUV- oder weichen Röntgenwellenlängenbereich und mindestens einer ersten Elektrode (20, 21, 140, 141), wobei zwischen dem optischen Element (18, 19, C1, C2) und der ersten Elektrode (20, 21, 140, 141) eine Potenzialdifferenz angelegt wird, **dadurch gekennzeichnet,**
**dass** im Betriebsmodus des optischen Systems während der Bestrahlung des optischen Elementes (18, 19, C1, C2) die erste Elektrode (20, 21, 140, 141) relativ zu dem optischen Element (18, 19, C1, C2) auf ein erstes Potenzial P₁₁ < P₀ gelegt wird.

2. Verfahren nach Anspruch 1, **dadurch gekennzeichnet, dass** im Kontaminationskontrollmodus des optischen Systems die erste Elektrode (20, 21, 140, 141) relativ zu dem optischen Element (18, 19, C1, C2) auf ein zweites Potenzial P₁₂ > P₀ gelegt wird.

3. Verfahren nach Anspruch 2, **dadurch gekennzeichnet, dass** während der Bestrahlung mindestens eine Umschaltung der ersten Elektrode (20, 21, 140, 141) von niedrigerem Potenzial P₁₁ auf höheres Potenzial P₁₂ und umgekehrt in regelmäßigen Zeitabständen durchgeführt wird.

4. Verfahren nach Anspruch 3, **dadurch gekennzeichnet, dass** die Umschaltung in den Kontaminationskontrollmodus einmal täglich durchgeführt wird.

5. Verfahren nach einem der Ansprüche 3 oder 4, **dadurch gekennzeichnet, dass** die Umschaltung in den Kontaminationskontrollmodus 1 mal bis 5mal pro 2 Stunden durchgeführt wird.

6. Verfahren nach einem der Ansprüche 2 bis 5, **dadurch gekennzeichnet, dass** die Zeitdauer des Kontaminationskontrollmodus kleiner der Zeitdauer des Betriebsmodus gewählt wird.

7. Verfahren nach einem der Ansprüche 2 bis 6, **dadurch gekennzeichnet, dass** die Zeitdauer des Kontaminationskontrollmodus 10 bis 60 Sekunden beträgt.

8. Verfahren nach einem der Ansprüche 2 bis 7, **dadurch gekennzeichnet, dass** eine gepulste Strahlung mit einer Pulsfrequenz verwendet wird und dass im Kontaminationskontrollmodus an die erste Elektrode (20, 21, 140, 141) eine Wechselspannung mit einer Frequenz gleich der Pulsfrequenz angelegt wird, wobei die Wechselspannung zwischen dem niedrigeren Potenzial P₁₁ und dem höheren Potenzial P₁₂ schwankt.

9. Verfahren nach Anspruch 8, **dadurch gekennzeichnet, dass** die Dauer des Kontaminationskontrollmodus 1 bis 10, vorzugsweise 4 bis 5, Pulsen der Strahlung entspricht.

10. Verfahren nach einem der Ansprüche 1 bis 9, **dadurch gekennzeichnet, dass** als erste Elektrode (20, 21, 140, 141) ein um das optische Element (18, 19, C1, C2) angeordnetes Gehäuse oder eine in der Nähe des optischen Elementes (18, 19, C1, C2) angeordnete Platte, Gitter oder Ring verwendet wird.

11. Verfahren nach einem der Ansprüche 1 bis 10, **dadurch gekennzeichnet, dass** mindestens eine zweite Elektrode (31) vorgesehen ist, die auf ein zweites Potenzial P₂ gelegt wird.

12. Verfahren nach Anspruch 11, **dadurch gekennzeichnet, dass** als erste Elektrode (20, 21, 140, 141) ein in der Nähe des optischen Elementes (18, 19, C1, C2) angeordnete Platte, Gitter oder Ring und als zweite Elektrode ein um das optische Element (18, 19, C1, C2) angeordnetes Gehäuse (31, 101) verwendet wird.

13. Verfahren nach einem der Ansprüche 11 oder 12, **dadurch gekennzeichnet, dass** das zweite Potenzial P₂ < P₀ ist.

14. Verfahren nach einem der Ansprüche 11 bis 13, **dadurch gekennzeichnet, dass** das zweite Potenzial P₂ sowohl im Betriebsmodus als auch im Kontaminationskontrollmodus auf ein Potenzial < P₀ gelegt wird.

15. Verfahren nach einem der Ansprüche 11 bis 14, **dadurch gekennzeichnet, dass** das zweite Potenzial P₂ konstant gehalten wird.

16. Verfahren nach einem der Ansprüche 1 bis 15, **dadurch gekennzeichnet, dass** zumindest im Kontaminationskontrollmodus dem optischen System ein Gas oder Gasgemisch zugeführt.

17. Verfahren nach Anspruch 16, **dadurch gekennzeichnet, dass** das Gas oder Gasgemisch auf die Oberfläche des mindestens einen optischen Elementes (18, 19, C1, C2) geleitet wird.

18. Verfahren nach einem der Ansprüche 2 bis 17, **dadurch gekennzeichnet, dass** in einem optischen System mit zwei oder mehr optischen Elementen (18, 19, C1, C2) jeweils nur ein optisches Element (18, 19, C1, C2) in den Kontaminationskontrollmodus geschaltet wird, während die übrigen optischen Elemente (18,19. C1, C2) im Betriebsmodus verbleiben.

19. Optisches System mit mindestens einem optischen Element (18, 19, C1, C2) für Strahlung im EUV- oder weichen Röntgenwellenlängenbereich, mit mindestens einer ersten Elektrode (20, 21, 140, 141) und mit einer eine Umschalteinrichtung (51, 51') aufweisenden variablen Spannungsquelle (50, 50') zur Erzeugung einer Potenzialdifferenz zwischen dem optischen Element (18, 19, C1, C2) und der ersten Elektrode (20, 21, 140, 141), wobei das optische Element (18, 19, C1, C2) auf einem Potenzial P₀ und die erste Elektrode (20, 21, 140, 141) auf einem Potenzial P₁ liegt, **dadurch gekennzeichnet, dass** die Spannungsquelle (50, 50') eingerichtet ist, das Potenzial P₁ von einem ersten Wert P₁₁ < P₀ im Betriebsmodus des optischen Systems während der Bestrahlung des optischen Elements (18, 19, C1, C2) auf einen zweiten Wert P₁₂ > P₀ im Kontaminationskontrollmodus des optischen Systems umzuschalten und umgekehrt.

20. Optisches System nach Anspruch 19, **dadurch gekennzeichnet, dass** die Umschalteinrichtung (51, 51') eine Zeitschalteinrichtung (52, 52') aufweist.

21. Optisches System nach einem der Ansprüche 19 oder 20, **dadurch gekennzeichnet, dass** die mindestens eine erste Elektrode (20, 21, 140, 141) eine Gaszuführeinrichtung (47) und mindestens einen Gasauslass (43) aufweist.

22. Optisches System nach Anspruch 21, **dadurch gekennzeichnet, dass** der mindestens eine Gasauslass (43) auf die optisch aktive Fläche des optischen Elementes (18, 19, C1, C2) gerichtet ist.

23. Optisches System nach einem der Ansprüche 19 bis 22, **dadurch gekennzeichnet, dass** die mindestens eine erste Elektrode (20, 21, 140, 141) ein in der Nähe des optischen Elementes (18, 19, C1, C2) angeordnetes Gitter, Ring oder Platte oder ein das optische Element (18, 19, C1, C2) umgebendes Gehäuse ist.

24. Optisches System nach einem der Ansprüche 19 bis 23, **dadurch gekennzeichnet, dass** die vom Gitter überdeckte Fläche größer als die Fläche des Strahlflecks ist.

25. Optisches System nach einem der Ansprüche 19 bis 24, **dadurch gekennzeichnet, dass** das optische Element (18, 19, C1, C2) eine elektrische Zuleitung (53) aufweist und auf ein beliebiges Potenzial P₀ legbar ist.

26. Optisches System nach einem der Ansprüche 19 bis 25, **dadurch gekennzeichnet, dass** mindestens eine zweite Elektrode vorgesehen ist, die räumlich weiter vom optischen Element (18, 19, C1, C2) entfernt angeordnet ist als die erste Elektrode (20, 21, 140, 141).

27. Optisches System nach einem der Ansprüche 19 bis 26, **dadurch gekennzeichnet, dass** die zweite Elektrode ein das optische Element (18,19, C1, C2) umgebendes Gehäuse (31, 101) ist und dass die erste Elektrode (20, 21,140,141) ein in der Nähe des optischen Elementes (18, 19, C1, C2) angeordnetes Gitter, Platte oder Ring ist.

28. Optisches System nach einem der Ansprüche 19 bis 27, **dadurch gekennzeichnet, dass** die zweite Elektrode auf einem Potenzial P₂ liegt mit P₂ < P₀.

29. Optisches System nach einem der Ansprüche 19 bis 28, **dadurch gekennzeichnet, dass** das optische Element (C1, C2) ein normal-incidence-Kollektorspiegel (C1, C2) ist.

30. Normal-incidence-Kollektorspiegel (C1, C2) für Strahlung im EUV- oder weichen Röntgenwellenlängenbereich, **gekennzeichnet durch** einen elektrischen Kontakt zum anschließen einer Spannungsquelle (50').

31. Normal-incidence-Kollektorspiegel (C1, C2) nach Anspruch 30, **gekennzeichnet durch** mindestens eine erste Elektrode (140, 141).

32. Optisches System mit mindestens einem normal-incidence-Kollektorspiegel (C1, C2) nach Anspruch 31, **gekennzeichnet durch** eine mit dem elektrischen Kontakt des normal-incidence-Kollektors und der ersten Elektrode verbundenen Spannungsquelle (50') zur Erzeugung einer Potenzialdifferenz zwischen dem normal-incidence-Kollektorspiegel (C1, C2) und der ersten Elektrode (140,141).

33. Optisches System nach Anspruch 32, **dadurch gekennzeichnet, dass** die Spannungsquelle (50') eingerichtet ist, im Betriebsmodus des optischen Systems während der Bestrahlung des normal-incidence-Kollektorspiegels (C1, C2) den normal-incidence-Kollektorspiegel (C1, C2) auf ein Potenzial P₀ und die erste Elektrode (140,141) auf ein Potenzial P₁ mit einem ersten Wert P₁₁ < P₀ zu legen.

34. Optisches System nach Anspruch 33, **dadurch gekennzeichnet**, das die Spannungsquelle (50') variabel ist und eine Umschalteinrichtung (51') aufweist, wobei die Spannungsquelle (50') eingerichtet ist, das Potenzial P₁ von dem ersten Wert P₁₁ < P₀ auf einen zweiten Wert P₁₂ > P₀ im Kontaminationskontrollmodus des optischen Systems umzuschalten und umgekehrt.
